# EUROPEAN PATENT APPLICATION

(11) **EP 4 160 494 A1**
(43) Date of publication of application: **05.04.2023**
(21) Application number: 21812010.3
(22) Date of filing: 26.05.2021
(51) Int. Cl.: G06Q 10/00

(54) **MANUFACTURED OBJECT INFORMATION MANAGEMENT DEVICE, METHOD, AND PROGRAM**

(30) Priority: 26.05.2020 JP 2020091792
(71) Applicant: NTT Communications Corporation, Tokyo 100-8019 (JP)
(72) Inventor: SAKAINO, Akira, Tokyo 100-8019 (JP); NIITSUMA, Hideaki, Tokyo 100-8019 (JP); SUZUKI, Yoichi, Tokyo 100-8019 (JP); ITO, Masataka, Tokyo 100-8019 (JP)
(74) Representative: Nederlandsch Octrooibureau
(86) International application number: PCT/JP2021/020052
(87) International publication number: WO 2021/241651

(57) **Abstract**

An equipment load and a management load imposed on a business operator are reduced, and those who intend to reuse manufactured products can reliably acquire support information necessary for reuse, thereby further promoting the reuse of the manufactured products. A product information management server SV collects attribute information, usage history information, maintenance history information, and CO₂ emission information regarding battery modules manufactured by a plurality of storage battery manufacturers, and stores the information in DBs 31-33 in association with each other. Where an information viewing request is received, reuse support information is generated based on the attribute information, usage history information, maintenance history information and CO₂ emission information of the corresponding battery module, and the generated reuse support information is transmitted to the requestor.

## Description

### FIELD

Embodiments of the present invention relate to a product information management device, a method, and a program used for managing information on manufactured products such as commercial products and parts.

### BACKGROUND

In recent years, reuse and recycling of products and parts have been promoted in order to effectively use resources. For example, Patent Document 1 describes a system for promoting reuse of battery modules that use secondary batteries. According to this system, a business operator uses an information processing device and collects usage history information on battery modules and log information on the charge/discharge of the battery modules from terminals used by users of the battery modules and charging/discharging devices of charging/discharging equipment, and the system provides information for collection in consideration of the failure, life span and safety of the battery modules, based on the collected usage history information and log information on the charge/discharge.

### CITATION LIST

### PATENT LITERATURE

Patent Literature 1: Jpn. Pat. Appln. KOKAI Publication 2015-50819

### SUMMARY

### TECHNICAL PROBLEM

According to the conventional system, however, each business operator independently collects and manages the usage history information and the log information on charge/discharge of battery modules, using the information processing device. For this reason, the equipment load and management load of each business operator are heavy, and some business operators may not be able to cope with this. In addition, since a person who intends to reuse battery modules needs to access the information processing devices of the business operators corresponding to the battery modules, there may be a case where desired support information cannot be obtained, which is a major obstacle to the promotion of the reuse of the battery modules.

The present invention has been made in view of the above circumstances, and one aspect of the present invention is to reduce the equipment load and management load imposed on the business operators, and to enable an information user to reliably acquire support information necessary for the use of manufactured products, thereby further promoting the reuse of the manufactured products.

### SOLUTION TO PROBLEM

To solve the above problem, an embodiment of the present invention provides a product information management device or a management method, which is capable of communicating, via a network, with a first management device used by each of a plurality of product manufacturers and a second management device used by each of a plurality of product users. Product attribute information representing attributes of a product is acquired from the plurality of first management devices via the network, and the acquired product attribute information is stored in a storage medium. Usage history information representing a usage history of the product is acquired from the plurality of second management devices via the network, and the acquired usage history information is stored in the storage medium in association with the product attribute information. Support information for each product for supporting reuse of the product is generated, based on each of the information stored in the storage medium. The generated support information is transmitted to a requestor via the network in response to an information viewing request regarding the product.

### ADVANTAGEOUS EFFECTS OF INVENTION

According to one embodiment of the present invention, the product information management device collects attribute information and usage history information on each product from a plurality of product manufacturers and a plurality of product users, and collectively manages the attribute information and usage history information. Based on these pieces of information, information for supporting reuse of products is generated, and this support information is provided to those who intend to reuse the products. Therefore, an information processing device does not have to be installed for each business operator to collect and manage product usage history information, etc., so that the equipment load and management load imposed on the business operators can be reduced. In addition, a person who intends to reuse a product simply sends an information viewing request to the product information management device, without reference to the manufacturer that manufactures the product, and yet acquires support information necessary for reusing the product, so that secondary use of the product, such as reuse and recycling, can be appropriately promoted.

That is, according to one embodiment of the present invention, the equipment load and management load on a business operator can be reduced, and the information user can reliably acquire the support information necessary for the reuse of the product, thereby providing a technology for further promoting reuse of products.

### BRIEF DESCRIPTION OF THE DRAWINGS

FIG. 1 is a diagram showing the overall configuration of a system including a product information management device according to one embodiment of the present invention.
FIG. 2 is a block diagram showing the hardware configuration of a product information management server that functions as the product information management device according to one embodiment of the present invention.
FIG. 3 is a block diagram showing the software configuration of the product information management server that functions as the product information management device according to one embodiment of the present invention.
FIG. 4 is a diagram showing an example of product attribute information managed in the product information management server shown in FIG. 3.
FIG. 5 is a diagram showing an example of usage history information managed by the product information management server shown in FIG. 3.
FIG. 6 is a diagram showing an example of maintenance history information managed by the product information management server shown in FIG. 3.
FIG. 7 is a flowchart showing a processing procedure and processing contents of management processing executed by the product information management server shown in FIG. 3 .

### DETAILED DESCRIPTION

Embodiments of the present invention will now be described with reference to the accompanying drawings.

### (One Embodiment)

In one embodiment of the present invention, a battery module using a lithium-ion secondary battery adapted for use in an electric vehicle (EV) is taken as an example of a manufactured product, and a description will be given of an example in which that battery module is reused.

### (Configuration Example)

### (1) System

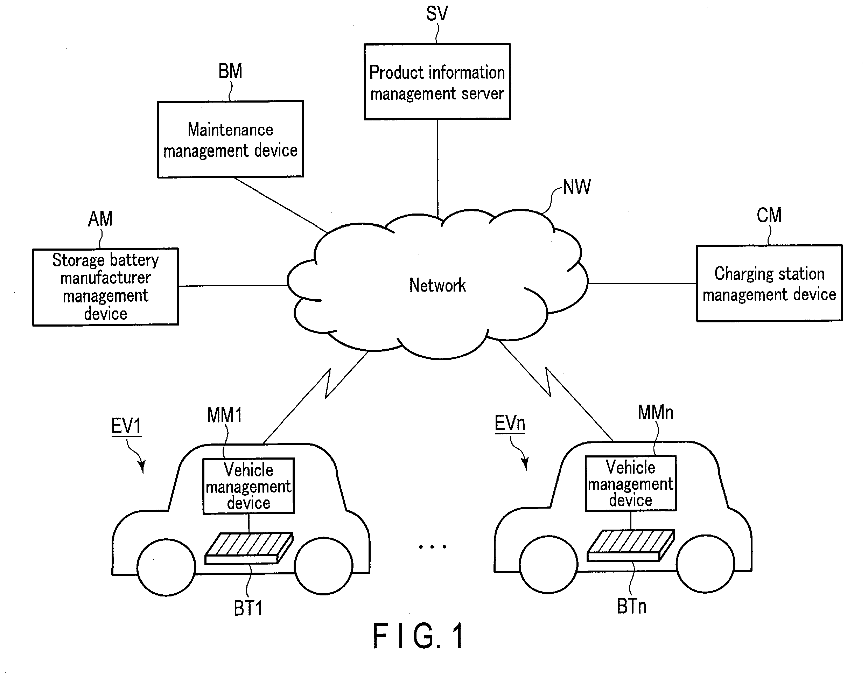

FIG. 1 is a diagram showing the overall configuration of a system that includes a product information management device according to one embodiment of the present invention.

In this example, the system includes a server computer (hereinafter referred to as a product information management server) SV that operates as a product information management device. The product information management server SV can perform data transmission, via a network NW, with vehicle management devices MM1 to MMn (second management devices) mounted on electric vehicles EV1 to EVn, storage battery manufacturer management devices AM (first management devices), maintenance management devices BM (third management devices), and charging station management devices CM (fourth management devices).

The network NW includes, for example, a wide area network using the Internet as a core network, and an access network for accessing this wide area network. As the access network, for example, a wired or wireless public network, a wired or wireless local area network (LAN), and a cable television (CATV) network are used.

For simplicity of illustration, FIG. 1 shows a state in which one storage battery manufacturer management device AM, one maintenance management device BM, and one charging station management device CM are connected to the network NW, but in actuality a plurality of management devices used by different manufacturers and business operators are connected.

### (2) Device

### (2-1) Electric Vehicles EV1 to EVn

The electric vehicles EV1 to EVn are provided with battery modules BT1 to BTn using lithium-ion secondary batteries. The vehicle management devices MM1 to MMn have a plurality of in-vehicle electronic control units (ECU) and a transmission control unit (TCU), which are connected to each other by an in-vehicle network referred to as control area network (CAN).

Each ECU is configured to perform a predetermined control function by causing a processor to execute a program. For example, the ECU is used as a device that controls a motor, transmissions, a steering angle, an accelerator, a brake, etc., a device that controls blinkers, lights, and wipers, a device that controls a door lock and the opening and closing of windows, a device that control air conditioning, or the like.

A large number of sensors are provided for each of the electric vehicles EV1 to EVn, including in-vehicle sensors for monitoring vehicle's operating conditions and driver's conditions, such as a speed sensor, a temperature sensor and a vibration sensor, and off-vehicle sensors for monitoring the situation outside the vehicle. The ECU is also used as a device that receives sensing data output from these sensors.

The vehicle management devices MM1-MMn are provided with an energy-management unit ECU for managing the usage states of the battery modules BT1-BTn. For example, the energy-management unit ECU monitors the usage states of the battery modules BT1 to BTn and generates and stores usage history information based on the results. The usage history information includes an "individual identification number", a "start date of use", and an "end date of use" of each of the battery modules BT1 to BTn. The usage history information may include "vehicle identification numbers" of the electric vehicles EV1 to EVn. The "individual identification numbers" are permanent identification information issued to the battery modules BT1 to BTn when the storage battery manufacturers manufacture the battery modules BT1 to BTn. The vehicle identification numbers are unique vehicle production numbers assigned to the electric vehicles when the vehicle manufacturer manufactures the electric vehicles EV1 to EVn.

The usage history information also includes "charging information" on the battery modules BT1 to BTn. As the charging information, at least one of, for example, the "number of times of charges", the "total cumulative charging time", and the "total charging power amount" is used. These values are measured by the energy-management unit ECU during use, updated to be latest values at all times, and stored in a nonvolatile memory semi-permanently.

Where the battery modules BT1 to BTn are provided with a battery management unit, the above information may be managed by the battery management unit, not by the energy-management unit ECU.

In a periodical manner or in response to a request made by the product information management server SV, the vehicle management devices MM1 to MMn transmit management information stored in the energy-management unit ECU or the battery management unit and representing the usage states of the battery modules BT1 to BTn, from the transmission control unit (TCU) to the product information management server SV via the network NW.

### (2-2) Storage Battery Manufacturer Management Device AM

The storage battery manufacturer management device AM is a server computer used by a storage battery manufacturer, and manages attribute information of manufactured battery modules. The attribute information includes an "individual identification number", a "manufacturer's name", a "manufacturing date" of a battery module, and an "upper limit value of use" determined according to a use application type. Examples of a use application type include a "power supply for an electric vehicle", an "emergency power supply for a building", and an "emergency power supply for a house". The upper limit value of use indicates the upper limit value of each of the "number of times of charges", the "total cumulative charging time", and the "total charging power amount".

The storage battery manufacturer management device AM includes a communication interface unit, and in a periodic manner or in response to a request made by the product information management server SV, transmits the attribute information on the battery module from the communication interface unit to the product information management server SV via the network NW.

### (2-3) Maintenance Management Device BM

The maintenance management device BM is used by a business operator who performs maintenance work, such as inspection, repair, and part replacement, for the battery modules BT1 to BTn mounted on the battery modules BT1 to BTn, and is a personal computer, for example. The maintenance management device BM generates maintenance history information, based on information entered by a worker who executes the maintenance work and representing work contents.

For example, where a part is replaced, a combination of the type of replacement part and the repair method is patterned, and a "maintenance pattern number", an "implementation date" of the replacement/repair, and a "maintenance operator" are included in the maintenance history information. Also, information specifying a correction rule of charging information included in the usage history information is generated for each maintenance pattern, and is included in the maintenance history information. The information specifying the correction rule specifies, for example, whether or not to reset the cumulative charging time included in the charging information of the usage history information.

The maintenance management device BM stores the generated maintenance history information in association with, for example, the individual identification number of the maintained battery module and a vehicle identification number. In a periodic manner or in response to a request made by the product information management server SV, the stored maintenance history information is transmitted to the product information management server SV via the network NW.

### (2-4) Charging Station Management Device CM

The charging station management device CM is, for example, a personal computer or a server computer, and is provided for each charging station or for a plurality of charging stations.

Where the battery modules BT1 to BTn are charged at a charging station, the charging station management device CM estimates an amount of CO₂ emissions for each type of power supply used in the charging process. At the same time, the estimation accuracy of the amount of CO₂ emissions is obtained. The estimated value of the amount of CO₂ emissions and the estimation accuracy are stored in association with the individual identification number of the charged one of the battery modules BT1 to BTn.

The charging station management device CM reads the estimated value of the amount of CO₂ emissions and the estimation accuracy in a periodic manner or in response to a request made by the product information management server SV, and transmits them to the product information management server SV via the network NW.

For example, an estimated value of the amount of CO₂ emissions is obtained by the following method. That is, each charging station can selectively use a plurality of types of power supply as a charging power supply. The types of power supply include, for example, "thermal power", "hydro power", "wind power", and "solar power". The types of power supply are not restricted to these.

The charging station management device CM estimates an amount of CO₂ emissions [g/kwh] generated in the process from power generation to power transmission/distribution, for each type of power supply. For example, an amount of CO₂ emissions per unit time (a unit emission amount for each type of power supply) is stored in advance in a memory for each type of power supply, a usage time and a usage amount are measured for each selected type of power, and the amount of CO₂ emissions required for charging is estimated, based on the measured values and the unit emission amount for each type of power supply.

The information indicating the unit emission amount for each type of power supply is obtained from power companies (power generation/transmission/distribution/retail companies), government reports, etc., and the values of the information are stored in a memory of the charging station management device CM as coefficients for each power retail company and for each type of power supply. The coefficients are updated each time information provided by the power companies or government reports are updated.

The method of estimating an amount of CO₂ emissions for each type of power supply is not limited to the above method. For example, parameters such as the type of fuel used for power generation, a power generation condition (e.g., weather), a power transmission distance, the charging capacity of a charging station, and the charging performance of a battery module may be further taken into consideration.

On the other hand, the estimation accuracy of the amount of CO₂ emissions can be obtained as a ratio between the value of the emission amount actually measured by the charging station management device CM and the estimation value calculated in the above estimation method. This estimation accuracy is used, for example, by a battery recycler to determine the credibility of the estimated value of the amount of CO₂ emissions when a battery module is recycled.

### (2-5) Product Information Management Server SV

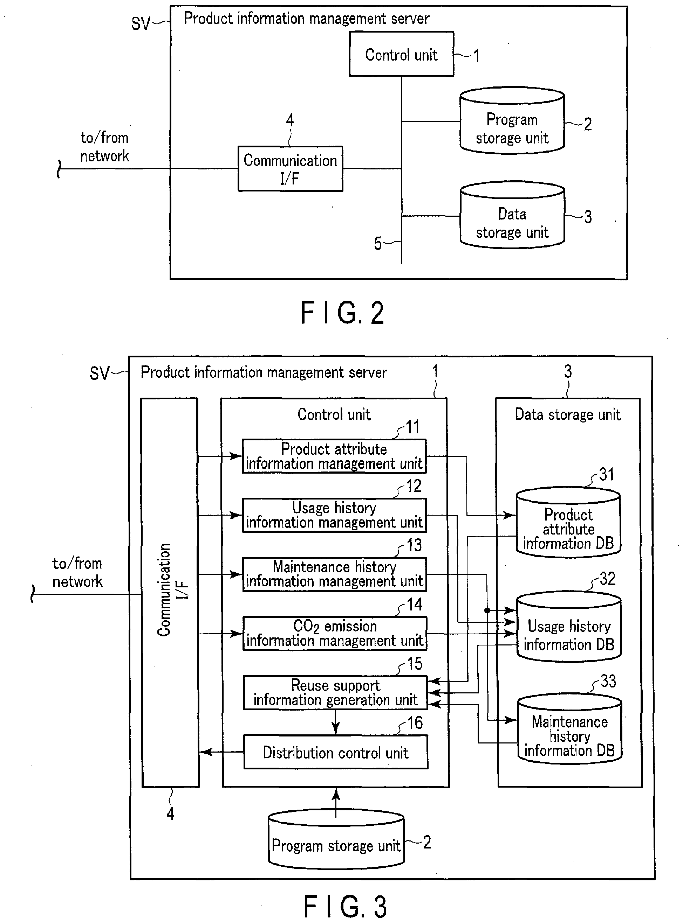

FIGS. 2 and 3 are block diagrams that show the hardware and software configurations of the product information management server (also referred to as a platform) SV, respectively.

The product information management server SV includes a control unit 1 having a hardware processor, such as a central processing unit (CPU), and a storage unit including both a program storage unit 2 and a data storage unit 3 and a communication interface (communication I/F) 4 are connected to the control unit 1 via a bus 5.

Under the control of the control unit 1, the communication I/F 4 uses a communication protocol defined by the network NW and performs data transmission between the vehicle management devices MM1 to MMn installed in the electric vehicles EV1 to EVn, the storage battery manufacturer management device AM, the maintenance management device BM and the charging station management device CM. The communication I/F 4 is, for example, an interface adapted for a wired network.

The program storage unit 2 is configured, for example, by combining a nonvolatile memory such as a hard disk drive (HDD) or a solid state drive (SSD) for which data write and data read can be performed at any time, with a nonvolatile memory such as a read only memory (ROM). The program storage unit 2 stores programs necessary for executing various control processes according to one embodiment of the present invention, in addition to middleware such as an operating system (OS).

The data storage unit 3 is configured, for example, by combining a nonvolatile memory (such as an HDD or an SSD) for which data write and data read can be performed at any time with a volatile memory such as a random access memory (RAM). The data storage unit 3 functions as a main storage unit necessary for implementing one embodiment of the present invention and is provided with a product attribute information database (the database will be hereinafter referred to as DB) 31, a usage history information DB 32, and a maintenance history information DB 33.

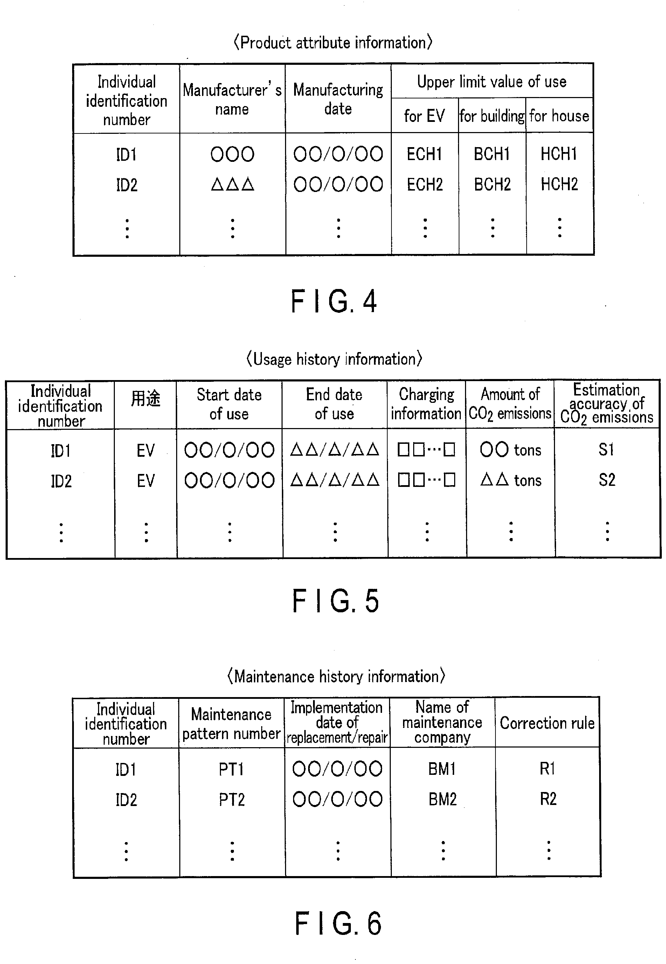

The product attribute information DB 31 is used to store the attribute information on battery modules acquired from the storage battery manufacturer management device AM. FIG. 4 shows an example of stored attribute information. This example shows a case where a "manufacturer's name", a "manufacturing date", and an "upper limit value of use" determined according to a use application type are stored in association with the "individual identification number" of a battery module.

The usage history information DB 32 is used to store usage history information on the battery modules BT1-BTn, which information is acquired from the vehicle management devices MM1-MMn of the electric vehicles EV1-EVn. This usage history information also includes information indicating the estimated value of the amount of CO₂ emissions and information on the estimation accuracy, which are acquired from the charging station management device CM.

FIG. 5 shows an example of stored usage history information. In this example, the "use application", "start day of use", "end day of use", "charging information", "estimated value of the amount of CO₂ emissions" and "estimation accuracy" of each of the battery modules BT1 to BTn are stored in association with the individual identification number of the corresponding one of the battery modules BT1 to BTn. The "charging information" includes at least one of the number of times of charges, the total cumulative charging time, and the total charging power amount, as described above.

The maintenance history information DB 33 is used to store information acquired from the maintenance management device BM and representing the maintenance history of the battery modules BT1 to BTn. FIG. 6 shows an example of stored maintenance history information. This example shows a case where a "maintenance pattern number", a "replacement/repair date", a "maintenance operator name" and a "correction rule" are stored in association with the individual identification numbers of the battery modules BT1 to BTn.

The control unit 1 includes, as processing functions according to one embodiment of the present invention, a product attribute information management unit 11, a usage history information management unit 12, a maintenance history information management unit 13, a CO₂ emission information management unit 14, a reuse support information generation unit 15 and a distribution control unit 16. These processing units 11 to 16 are implemented by causing the hardware processor of the control unit 1 to execute the programs stored in the program storage unit 2.

Where a new registration request is transmitted from the storage battery manufacturer management device AM via the network NW, the product attribute information management unit 11 receives, via the communication I/F 4, attribute information on the battery modules BT1 to BTn subsequently transmitted from the storage battery manufacturer management device AM and stores the received attribute information in the product attribute information DB 31.

The usage history information management unit 12 receives, via the communication I/F 4, usage history information on the battery modules BT1 to BTn, which is transmitted from the vehicle management devices MM1 to MMn of the electric vehicles EV1 to EVn via the network NW, and stores the received usage history information in the usage history information DB 32 in association with the individual identification numbers of the battery modules BT1 to BTn.

The maintenance history information management unit 13 receives, via the communication I/F 4, maintenance history information on the battery modules BT1 to BTn transmitted from the maintenance management device BM via the network NW, and stores the received maintenance history information in the maintenance history information DB 33.

The CO₂ emission information management unit 14 receives, via the communication I/F 4, information indicating an estimated value of the amount of CO₂ emissions for each type of power supply and the estimation accuracy, which information is transmitted from the charging station management device CM via the network NW, and stores the received information on the estimated value of the amount of CO₂ emissions and the estimation accuracy in the usage history information DB 32.

The reuse support information generation unit 15 generates information for supporting the reuse of a battery module, based on the usage history information (the estimated value of the amount of CO₂ emissions and the estimation accuracy) stored in the usage history information DB 32 and the maintenance history information stored in the maintenance history information DB 33, for each of the battery modules whose attribute information is stored in the product attribute information DB 31. An example of this reuse support information will be described later.

For example, where an information viewing request about a target battery module is received from a terminal of a battery module recycling company or a user of the battery module (a user of electric vehicles EV1 to EVn), the distribution control unit 16 compares the identification number of the battery module included in the information viewing request with the attribute information stored in the product attribute information DB 31 and determines whether or not the corresponding battery module is present. Where it is determined that information about the corresponding battery module is present, the reuse support information generated by the reuse support information generation unit 15 is transmitted from the communication I/F 4 to the terminal of a requestor in which the request is made.

### (Operation Example)

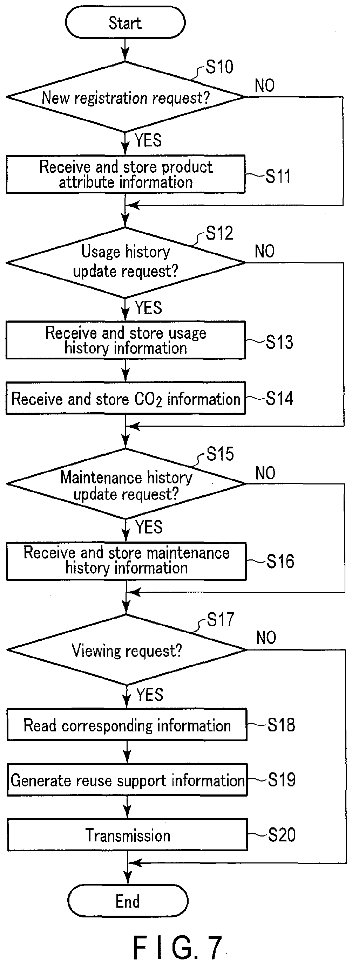

Next, an operation example of the product information management server SV configured as above will be described. FIG. 7 is a flowchart showing an example of a processing procedure and processing contents of the product information management server SV.

### (1) Registration of Product Attribute Information

Each time a new battery module is manufactured, the storage battery manufacturer management device AM generates attribute information on the manufactured battery module, and the generated attribute information is transmitted to the product information management server SV together with a new registration request. The attribute information may be collectively transmitted when a transmission request is received from the product information management server SV.

On the other hand, the control unit 1 of the product information management server SV monitors whether or not a new registration request is received from the storage battery manufacturer management device AM in step S10, under the control of the product attribute information management unit 11. Where a new registration request is received in this state, the product attribute information management unit 11 receives attribute information transmitted from the storage battery manufacturer management device AM via the communication I/F 4 in step S11, and stores the received attribute information in the product attribute information DB 31, as shown in FIG. 4, for example. Where attribute information having the same individual identification number is received again, the storage of the attribute information may be refused; alternatively, a confirmation request may be transmitted to the storage battery manufacturer management device AM, and only where consent is obtained in reply thereto, the corresponding attribute information may be stored for updating.

### (2) Management of Usage History Information

The battery modules BT1 to BTn are mounted on the electric vehicles EV1 to EVn by vehicle manufacturers. A battery module can also be used as an emergency power supply for a building or as an emergency power supply for a house, and its use application is not limited to the above examples.

Where the use of the battery modules BT1 to BTn mounted on the electric vehicles EV1 to EVn is started, the vehicle management devices MM1 to MMn generate and store usage history information, based on the usage states of the battery modules BT1 to BTn. As described above, the usage history information includes an "individual identification number", a "start date of use", an "end date of use", and "charging information" of each of the battery modules BT1 to BTn, and "vehicle identification numbers" of the electric vehicles EV1 to EVn. As the "charging information", for example, at least one of the "number of times of charges", "total cumulative charging time", and "total charging power amount" is used.

Each time the usage history information is updated or each time a predetermined date and time elapses, the vehicle management devices MM1 to MMn transmit the latest usage history information to the product information management server SV, together with update requests. The usage history information may be transmitted in response to a transmission request sent from the product information management server SV.

On the other hand, the control unit 1 of the product information management server SV monitors reception of the usage history update request transmitted from each of the vehicle management devices MM1 to MMn in step S12 under the control of the usage history information management unit 12. Where an update request is received in this state, the usage history information management unit 12 receives the usage history information transmitted from the vehicle management devices MM1 to MMn via the communication I/F 4 in step S13. The individual identification number of the battery module included in the received usage history information is compared with the individual identification number included in each of the attribute information registered in the product attribute information DB 31, and where the same individual identification number is present, the received usage history information is stored in the usage history information DB 32 for updating, as shown in FIG. 5, for example. It should be noted that usage history information for which no individual identification number is registered is not stored in the usage history information DB 32.

Similarly thereafter, each time new usage history information is transmitted from the vehicle management devices MM1 to MMn, the usage history information management unit 12 receives the usage history information and stores it in the usage history information DB 32.

### (3) Management of Information on Amount of CO₂ Emissions

Where the battery modules BT1 to BTn are charged at a charging station, the charging station management device CM estimates an amount of CO₂ emissions for each type of power supply used for this charging. At the same time, an estimation accuracy of the amount of CO₂ emissions is calculated.

As described above, the process for estimating an amount of CO₂ emissions is performed, for example, by storing an amount of CO₂ emissions per unit time in a memory for each type of power supply (unit emission amount for each type of power supply) in advance, measuring a usage time and a usage amount for each power type selected for the charging, and calculating an amount of CO₂ emissions required for the charging, based on the measured values and the unit emission amount for each type of power supply. Further, the estimation accuracy of the amount of CO₂ emissions is calculated as a ratio between the amount of emissions actually measured by the charging station management device CM and the estimation value calculated by the above estimation method.

For example, each time the values are updated or each time a predetermined date and time elapses, information indicating the estimated value of the amount of CO₂ emissions and information on the estimation accuracy are transmitted to the product information management server SV together with the identification numbers of the individual battery modules BT1 to BTn for which charging is performed. The information indicating the estimated value of the amount of CO₂ emissions and the information on the estimation accuracy may be transmitted in response to a transmission request from the product information management server SV.

Where the information indicating the estimated value of the amount of CO₂ emissions and the information on the estimation accuracy are transmitted from the charging station management device CM, the control unit 1 of the product information management server SV receives the transmitted information via the communication I/F 4 in step S14, under the control of the CO₂ emission information management unit 14. Based on the individual identification number of the battery module received concurrently, the information indicating the estimated value of the amount of CO₂ emissions and the estimation accuracy is stored in the corresponding usage history information of the usage history information DB 32 for updating, as shown in FIG. 5, for example.

Similarly thereafter, each time the information indicating a new estimated value of the amount of CO₂ emissions and the information on the estimation accuracy are transmitted from the charging station management device CM, the CO₂ emission information management unit 14 receives the CO₂ emission information and stores it in the usage history information DB 32.

### (4) Management of Maintenance History Information

For example, where a maintenance company run by a dealer or the like performs maintenance work on a battery module, the operator enters maintenance history information to the maintenance management device BM. For example, where a part such as a battery pack is replaced, the operator enters a "maintenance pattern number" indicating the combination of the type of replacement part and the repair method, an "implementation date" of replacement/repair, and a "name of the maintenance company". In addition, the operator enters information specifying a "correction rule" for correcting the number of times of charges of the battery module for each maintenance pattern.

The maintenance management device BM regards each of the entered information as maintenance history information, and stores it in the memory of the device in association with the individual identification number of the battery module for which maintenance is performed. Each time new maintenance history information is generated, each time the contents of the maintenance history are updated, or each time a predetermined date and time elapses, the maintenance history information is transmitted to the product information management server SV along with an update request. The maintenance history information may be transmitted in response to a transmission request sent from the product information management server SV.

On the other hand, the control unit 1 of the product information management server SV monitors reception of a maintenance history update request transmitted from the maintenance management device BM in step S15 under the control of the maintenance history information management unit 13. Where an update request is received in this state, the maintenance history information management unit 13 receives, via the communication I/F 4, the maintenance history information transmitted from the maintenance management device BM in step S16. The individual identification number of the battery module included in the received maintenance history information is compared with the individual identification number included in the attribute information registered in the product attribute information DB 31, and where the same individual identification number is present, the received maintenance history information is stored in the maintenance history information DB 33 for updating, as shown in FIG. 6, for example. It should be noted that maintenance history information for which no individual identification number is registered is not stored in the maintenance history information DB 33.

Where the maintenance history information management unit 13 receives the maintenance history information, the maintenance history information management unit 13 corrects the cumulative number of times of charges of the corresponding usage history information stored in the usage history information DB 32, according to the correction rule included in the maintenance history information. For example, where all battery packs are replaced, the cumulative number of times of charges is reset to zero, and the number of times of charges recorded thereafter is used as an actual usage amount. Where only some of the battery packs are replaced, only the cumulative number of times of charges corresponding to the replaced battery packs included in the cumulative number of times of charges managed for each of the battery packs is reset to zero.

### (5) Generation and Distribution of Reuse Support Information

In step S17, under the control of the distribution control unit 16, the control unit 1 of the product information management server SV monitors information viewing requests for battery modules, which are transmitted, for example, from battery module recycling companies or users of the battery modules, namely, from users of the electric vehicles EV1 to EVn. Where an information viewing request is received in this state, the distribution control unit 16 compares the individual identification number of the battery module included in the information viewing request with the attribute information stored in the product attribute information DB 31 to determine whether or not the corresponding battery module is present.

Where the distribution control unit 16 determines that information on the corresponding battery module is present, the control unit 1 of the product information management server SV reads the product attribute information, usage history information and maintenance history information of the corresponding battery module from the product attribute information DB 31, the usage history information DB 32, and the maintenance history information DB 33 in step S18, under the control of the reuse support information generation unit 15. In step S19, the reuse support information generation unit 15 generates reuse support information, as described below, based on the read information.

For example, the upper limit value of use for the corresponding use application is first selected from the product attribute information, based on the information included in the information viewing request and indicating the use application of the corresponding battery module. Next, one of the number of times of charges, the total cumulative charging time, and the total amount of charging power, which are included in the usage history information as charging information, is compared with the selected upper limit value of use. Based on the result of the comparison, information indicating whether or not the corresponding battery module can be reused is generated, and the number of remaining times of charges, the remaining cumulative charging time or the remaining charging power of the battery module is calculated. Then, reuse support information is generated, including the information indicating whether or not the battery module can be reused, the calculated number of remaining times of charges, the remaining cumulative charging time, or an estimated value of remaining charging power of the battery module.

The reuse support information generation unit 15 includes the estimated value of the amount of CO₂ emissions included in the usage history information and information representing the credibility thereof, in the reuse support information. At the time, the estimated value of the amount of CO₂ emissions may be compared with a preset threshold value, and based on the comparison result, evaluation information may be generated for the type of power supply used for charging the battery module, and the generated evaluation information may be included in the reuse support information. The evaluation information on the type of power supply can be used as reference information which the user of the battery module, that is, the user of the electric vehicle, can use for determining which type of power supply should be selected when the battery module is charged thereafter at the charging station.

Furthermore, a possible resale price of the product when reusing the battery module may be determined based on the estimated value of the amount of CO₂ emissions, and the determined possible resale price of the product may be included in the reuse support information. In this case, the smaller the amount of CO₂ emitted for charging the battery module, the higher the possible resale price or trade-in price of the battery module. With the resale price determined as above, the user of the battery module positively chooses a power supply that uses renewable energy as a power supply for charging, in order to maximize the appraisal price of the battery module when the electric vehicle is traded in. As a result, the amount of CO₂ emissions required for using the battery module can be reduced.

The distribution control unit 16 transmits the reuse support information generated as above from the communication I/F 4 to the terminal of the requestor in step S20.

### (Operations and Advantages)

As described above, according to one embodiment, the product information management server SV collects attribute information, usage history information, maintenance history information, and CO₂ emission information on battery modules manufactured by a plurality of storage battery manufacturers, and stores these pieces of information in the DBs 31 to 33 in association with each other. Where an information viewing request is received, reuse support information is generated based on the attribute information, usage history information, maintenance history information and CO₂ emission information of the corresponding battery module, and the generated reuse support information is transmitted to the requestor.

Therefore, the product information management server SV can collectively manage various kinds of information on battery modules manufactured by different storage battery manufacturers. As a result, there is no need to provide an information processing device for each business operator to collect and manage usage history information on battery modules, etc., and the equipment load and management load which may be imposed on each business operator can be reduced.

A business operator who reuses battery modules is only required to transmit an information viewing request to the product information management server SV and yet reliably acquires support information necessary for the reuse of the battery modules, without reference to the storage battery manufacturers that made the battery modules, the use applications for which the battery modules were manufactured, and the maintenance companies that performed the maintenance of the battery modules. Thus, the reuse of the battery modules can be appropriately promoted.

The estimated value of the amount of CO₂ emissions and the information on the credibility thereof are included in the reuse support information, so that the reuse company can reuse the battery modules more appropriately. Further, the estimated value of the amount of CO₂ emissions can be compared with a preset threshold value, evaluation information regarding the type of power supply used for charging the battery module can be generated based on the comparison result, and the generated evaluation information can be included in the reuse support information. Thus, where the user of the battery module, that is, the user of an electric vehicle, can use the evaluation information as reference information when the user selects a type of power supply and charges the battery module at a charging station.

Based on the estimated amount of CO₂ emissions, a possible resale price of a battery module can be determined such that the smaller the amount of CO₂ emissions is, the higher will be the possible resale price. With the possible resale price being determined in this manner and included in the reuse support information, the user of the battery module can positively choose a power supply that uses renewable energy as a power supply for charging, in order to maximize the appraisal price of the battery module when the electric vehicle is traded in. As a result, the amount of CO₂ emissions necessary for using the battery module can be reduced.

### (OTHER EMBODIMENTS)

(1) In connection with the above embodiment, reference was made to an example in which the estimated value of the amount of CO₂ emissions is transmitted from the charging station management device CM to the product information management server SV. The present invention, however, is not limited to this, and an estimated value of the amount of CO₂ emissions corresponding to the type of power supply used for charging may be transferred from the charging station management device CM to the vehicle management devices MM1 to MMn of the electric vehicles EV1 to EVn, and the estimated value of the amount of CO₂ emissions can be transmitted from the vehicle management devices MM1 to MMn to the product information management server SV.
(2) In connection with the above embodiment, reference was made to an example in which only the reuse support information is transmitted to the terminal of a requestor in which a viewing request is made. The present invention, however, is not limited to this, and product attribute information, usage history information and maintenance history information may be transmitted instead of the reuse support information, and the product attribute information, usage history information and maintenance history information may be transmitted in addition to the reuse support information. Further, a menu of each of the above information may be presented to an information viewing requestor, and information selected from the presented menu may be selectively transmitted.

Although the embodiments of the present invention have been described in detail, the above description is merely illustrative of the present invention in every respect. For example, products need not be the battery modules for automobiles but may be facility equipment used in offices, plants and houses, home appliances, information communication devices such as computers, servers and network devices, lighting devices, air conditioners, work machinery and robots, industrial equipment such as conveyors, transportation vehicles such as automobiles, trucks and buses, construction machinery, etc. The products may also include parts used in the above-mentioned products, such as motors, compressors and electronic parts.

Needless to say, the type and configuration of the product information management device, processing procedure and processing contents, the data structure and generation location of the product attribute information, usage history information and maintenance history information, types of parameters used for estimating an amount of CO₂ emissions, the calculation method, the calculation location, etc. can be improved or modified in various manners without departing from the scope of the present invention. That is, in implementing the present invention, a specific configuration according to the embodiments may be appropriately adopted.

That is, the present invention is not limited to the above-described embodiments and can be embodied in practice by modifying the structural elements without departing from the gist of the invention. In addition, various inventions can be made by properly combining the structural elements disclosed in connection with the above embodiments. For example, some of the structural elements may be deleted from the embodiments. Furthermore, structural elements of different embodiments may be combined.

### REFERENCE SIGNS LIST

- SV: Product Information Management Server
- AM: Storage Battery Manufacturer Management Device
- BM: Maintenance Management Device
- CM: Charging Station Management Device
- EV1, EVn: Electric Vehicle
- MM1, MMn: Vehicle Management Device
- BT1, BTn: Battery Module
- 1: Control Unit
- 2: Program Storage Unit
- 3: Data Storage Unit
- 4: Network
- 5: Bus
- 11: Product Attribute Information Management Unit
- 12: Usage History Information Management Unit
- 13: Maintenance History Information Management Unit
- 14: CO₂ Information Management Unit
- 15: Reuse Support Information Generation Unit
- 16: Distribution Control Unit
- 31: Product Attribute Information Database
- 32: Usage History Information Database
- 33: Maintenance History Information Database

## Claims

1. A product information management device capable of communicating, via a network, with a first management device used by each of a plurality of product manufacturers and a second management device used by each of a plurality of product users, the product information management device comprising:
a first management unit configured to acquire product attribute information representing attributes of a product from the plurality of first management devices via the network, and that stores the acquired product attribute information in a storage medium;
a second management unit configured to acquire usage history information representing a usage history of the product from the plurality of second management devices via the network, and that stores the acquired usage history information in the storage medium in association with the product attribute information;
a support information generation unit configured to generate for each product support information for supporting reuse of the product, based on each of the information stored in the storage medium; and
a transmission unit configured to transmit the generated support information to a requestor via the network in response to an information viewing request regarding the product.

2. The product information management device according to claim 1, being further capable of communicating, via the network, with a third management device used by a business operator that performs maintenance of the product,
the product information management device further comprising a third management unit configured to acquire maintenance history information representing a maintenance history of the product from the third management device via the network, and that stores the acquired maintenance history information in the storage medium in association with the product attribute information.

3. The product information management device according to either one of claims 1 and 2, being further capable of communicating, via the network, with a fourth management device that manages estimation information on an amount of CO₂ emissions generated during use of the product,
the product information management device further comprising a fourth management unit configured to acquire the estimation information on the amount of CO₂ emissions regarding the product via the network and store in the storage medium the acquired estimation information on the amount of CO₂ emissions, as being included in the usage history information or in association with the usage history information.

4. The product information management device according to any one of claims 1 to 3, wherein
the product attribute information includes information representing an upper limit value of use of the product,
the usage history information includes information representing a cumulative usage time, a number of times used, or an amount of usage, and
the support information generation unit is configured to compare the cumulative usage time, the number of times used or the amount of usage with the upper limit value of use, and generates the support information regarding reuse of the product, based on a comparison result.

5. The product information management device according to claim 4, wherein
the product is a secondary battery,
the product attribute information includes information representing an upper limit value of use of the secondary battery,
the usage history information includes information representing one of a number of times of charges, a total cumulative charging time and a total amount of charging power of the secondary battery, and
the support information generation unit is configured to compare one of the number of times of charges, the total cumulative charging time, and the total amount of charging power included in the usage history information with the upper limit value of use included in the product attribute information, and generates information indicating whether the secondary battery is reusable, based on a comparison result.

6. The product information management device according to claim 4, wherein
the product is a secondary battery,
the product attribute information includes information representing an upper limit value of use of the secondary battery,
the usage history information includes information representing one of a number of times of charges, a total cumulative charging time, and a total amount of charging power of the secondary battery, and
the support information generation unit is configured to compare one of the number of times of charges, the total cumulative charging time and the total amount of charging power of the secondary battery included in the usage history information with the upper limit value of use included in the product attribute information, and generates information representing an estimation value of at least one of a remaining number of times of charges, a remaining cumulative charging time, or a remaining amount of charging power of the secondary battery, based on a comparison result.

7. The product information management device according to claim 4, wherein
the product is a secondary battery,
the product attribute information includes information representing a plurality of upper limit values of use that are predetermined for respective use applications of the secondary battery,
the usage history information includes information representing one of a number of times of charges, a total cumulative charging time and a total amount of charging power of the secondary battery, and information representing a use application of the secondary battery, and
the support information generation unit is configured to select a corresponding upper limit value of use from the product attribute information, based on information representing the use application of the secondary battery included in the usage history information, compares one of a number of times of charges, a total cumulative charging time and a total amount of charging power of the secondary battery included in the usage history information with the selected upper limit value of use, and generates information for supporting reuse of the secondary battery based on a comparison result.

8. The product information management device according to claim 2, wherein
the maintenance history information includes information indicating a history of part replacement performed for the product, information indicating a combination pattern between a type of the part replacement and a repair method, and information indicating a correction rule of the usage history information corresponding to the combination pattern, and
each time the maintenance history information is acquired, the third management unit is configured to update the usage history information stored in the storage medium, based on the information indicating the history of the part replacement, the information indicating the combination pattern between the type of the part replacement and the repair method, and the information indicating the correction rule of the usage history information corresponding to the combination pattern included in the maintenance history information.

9. The product information management device according to claim 3, wherein
the product is a secondary battery, and
the support information generation unit is configured to compare the estimation information on the amount of CO₂ emissions stored in the storage medium with a preset threshold value, and generates evaluation information for a type of power supply used for charging the secondary battery, based on a comparison result.

10. The product information management device according to claim 3, wherein
the product is a secondary battery, and
the support information generation unit is configured to determine a price, based on the estimation information on the amount of CO₂ emissions stored in the storage medium, such that a possible resale price of the secondary battery increases as the amount of CO₂ emissions decreases, and includes the determined possible resale price in the support information.

11. A product information management method executed by an information processing device capable of communicating, via a network, with a first management device used by a product manufacturer and a second management device used by a product user, comprising:
acquiring product attribute information representing attributes of a product from the first management device via the network and storing the acquired product attribute information in a storage medium;
acquiring usage history information representing a usage history of the product from the second management device via the network, and storing the acquired usage history information in the storage medium in association with the product attribute information;
generating, for each product, support information for supporting reuse of the product, based on each of the information stored in the storage medium; and
transmitting the generated support information to a requestor via the network in response to an information viewing request regarding the product.

12. A program for causing a processor of the product information management device according to any one of claims 1 to 10 to execute processing of each unit included in the product information management device.
